# EUROPEAN PATENT SPECIFICATION

(11) **EP 0 524 818 B1**
(45) Date of publication and mention of the grant of the patent: **08.10.1997**
(21) Application number: 92306724.3
(22) Date of filing: 23.07.1992
(51) Int. Cl.: H01L 23/522, H01L 21/768

(54) **Multi-layer wiring structure in a semiconductor device and method of manufacturing the same**
Mehrlagige Verbindungsstruktur für eine Halbleiter- vorrichtung und Verfahren zu ihrer Herstellung
Structure d'interconnexions multicouches pour un dispositif semi-conducteur, et procédé pour sa fabrication

(30) Priority: 23.07.1991 JP 206564/91
(43) Date of publication of application: 27.01.1993
(73) Proprietor: NEC CORPORATION, Tokyo (JP)
(72) Inventor: Morishita, Yasuyuki, Minato-ku, Tokyo 108-01 (JP)
(74) Representative: Abnett, Richard Charles

(56) References cited:
- EP-A- 0 345 875
- EP-A- 0 380 327
- US-A- 4 800 176
- 1987 SYMPOSIUM ON VLSI TECHNOLOGY, DIGEST OF TECHNICAL PAPERS May 1987, Karuizawa JP, pp. 77-78; M. KAKUMUet al.: 'PASPAC (Planaraized Al/Silicide/Poly Si With Self Aligned Contact) with low resistance and high reliability in CMOS LSIs'
- PATENT ABSTRACTS OF JAPAN, vol. 16, no. 134 (E-1185) 6 April 1992; & JP-A-32 95 230
- IBM TECHNICAL DISCLOSURE BULLETIN, vol. 32, no. 4A, September 1989, New York US, pp. 424-426; 'Coaxial Interconnections Using Advanced Metallurgy Technology'

## Description

### Background of the Invention

### Field of the invention

The present invention relates to a multi-layer wiring structure in a semiconductor device and a method for manufacturing the same.

### Description of related art

In a typical conventional process of manufacturing a semiconductor device, a multi-layer wiring formation using a plating method has been performed for example as follows:

A lower level wiring conductor is formed on a field insulator film formed on a semiconductor substrate, and then, an interlayer insulating film is formed. Thereafter, a through hole is formed for connecting between the lower level wiring conductor and a possible upper level wiring conductor. In the case of an electroplating method, a conducting film is formed as an electric current supplying layer.

In addition, a photoresist is coated on the conducting film, and then, patterned into a desired shape by photolithography. By the electroplating process, an upper level wiring conductor is formed on a portion of the conducting film that is not covered by the photoresist.

Thereafter the photoresist is removed, and an exposed portion of the conducting film is removed, so that a desired wiring conductor is obtained.

In the above mentioned conventional multi-layer wiring forming process using electroplating, the shape of the upper level wiring conductor becomes concave or recessed to reflect the shape of the lower level wiring conductor and the shape of the through hole portion for connecting between the upper level wiring conductor and the lower level wiring conductor. Therefore, if the number of the conductor levels becomes large in the multilayer wiring structure, it becomes difficult to planarize, and in addition, it is also becomes difficult to form a wiring conductor in the uppermost level.

Several methods for maintaining a planar surface at the top of a structure interconnecting two layers of a semiconductor structure are known, but these do not use electrodeposited connections between the layers.

These known methods are as follows.

A paper by Kakum et al published in the 1987 Symposium on VLSI Technology, Digest of Technical Papers, May 1987, Karuizawa, Japan, pages 77-78 describes a method for interconnecting an Al or Al/Si layer with a Si substrate. An insulating layer with a through hole is first formed over the Si substrate. Successive layers of polysilicon and Mo silicide are then deposited, extending across the upper surface of the insulating layer, down the side walls of the hole and across the exposed Si substrate at the base of the through hole. The surface of the Mo silicide is then oxidised to form an insulating SiO₂ layer, and the through hole is filled with a deposit of polysilicon. The upper surface of the structure is then etched back to remove the exposed portion of the SiO₂ layer from the upper surface of the insulating layer and to leave a substantially planar surface on which the Al or Al/Si conducting layer can be deposited.

US Patent No. 4800176 describes a method and structure substantially identical to that described by Kakum. In addition, US-A-4800176 describes an alternative method in which no MoSi layer is deposited and in which the SiO₂ insulating layer is formed by oxidising the polysilicon layer before the through hole is filled with polysilicon.

In each of these structures the function of the SiO₂ layer appears to be (as described in US-A-4800176 at column 3, line 65, to column 4, line 5) to provide a stopper for limiting the etching of the structure later on in the described process. When the polysilicon is deposited to fill the through hole, it deposits also on the upper surface of the structure beside the through hole and must then be etched back so that it is only present within the through hole. The SiO₂ layer limits this etching process.

European Patent Application No. EP-A-0380327 describes a method for connecting a metal wiring strip to a Si substrate. Two insulating layers are deposited over the substrate, a lower layer of phosphosilicate glass and an upper layer of SiO₂. A through hole is formed in both layers in two steps, by an isotropic etch step followed by an anisotropic etch step resulting in a parallel sided through hole in the phosphosilicate glass layer and an outwardly flared hole in the SiO₂ layer. The funnel-shaped through hole so formed is then filled with polysilicon to form an interconnection structure. The funnel-shaped through hole enhances the polysilicon deposition so as to produce a planar upper surface to the structure.

### Summary of the Invention

The invention provides a multilayer wiring structure in a semiconductor device, and a method for making the same, as defined in the appendant claims to which reference should now be made. Advantageous or preferred features of the invention are defined in dependent subclaims.

In a preferred embodiment the present invention may thus provide a multi-layer wiring structure for a semiconductor device in which the shape of the upper level wiring conductor is not limited by the lower level wiring conductor and the shape of the through hole, and therefore, in which the upper level wiring conductor is relatively planar.

Advantageously, the method of the invention may allow formation of a multi-layer structure, which can form a relatively planar upper level wiring conductor without being limited in its shape by the lower level wiring conductor and the shape of the through hole.

The above and other objects, features and advantages of the present invention will be apparent from the following description of preferred embodiments of the invention with reference to the accompanying drawings.

### Brief Description of the Drawings

Figures 1A to 1G are sectional views illustrating, in order, various steps of a first embodiment of the method in accordance with the invention; and
Figure 2 is a sectional view illustrating a second embodiment of the invention.

### Description of the Preferred embodiments

Now, preferred embodiments of the present invention will be described by way of illustration with reference to the accompanying drawings.

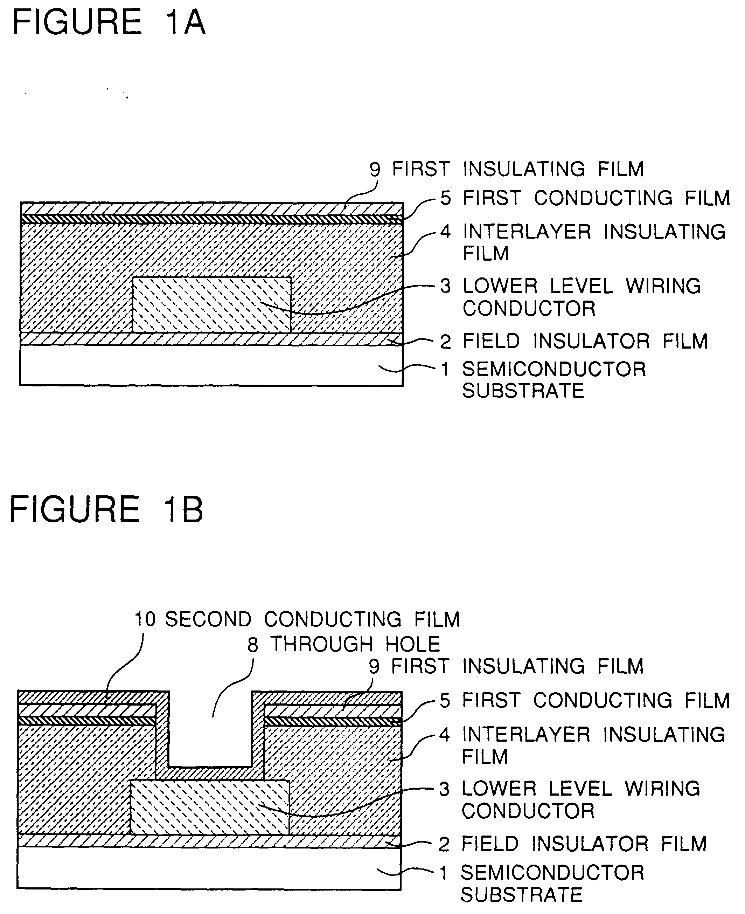

As shown in Figure 1A, a semiconductor substrate 1, on which semiconductor circuits elements are formed, is isolated with a field insulator film 2, and a gold wiring conductor of a desired pattern is formed on the field insulator film 2 by an electroplating process, so as to form a lower level wiring conductor 3.

An interlayer insulating film 4 is formed on the lower level wiring conductor 3, and then, is planarized. For example, this interlayer insulating film 4 can be formed by growing a silicon oxide film by a CVD process, and then, by spin-coating a polyimide layer, and by heating the coated polyimide layer.

On the planarized interlayer insulating film 4, a first conducting film 5 is formed for example by sputtering titanium or an alloy of titanium so as to have a thickness of about 0.1 µm. Thereafter, a first insulating film 9 is formed by depositing a silicon oxynitride film by a CVD process so as to have a thickness of about 0.1 µm to 0.2 µm.

As shown in Figure 1B, a through hole 8 of a desired size is formed at a position where it is desired to connect between the lower level wiring conductor 3 and a possible upper level wiring conductor, and then, a second conducting film 10 is formed to coat the overall surface by sputtering for example titanium or an alloy of titanium so as to have a thickness of about 0.1 µm.

The through hole 8 can be formed by, for example, forming a photoresist on all places other then the position where the through hole is to be formed, removing the first insulating film 9 and the first conducting film 5 by reactive ion etching using for example a CF₄ gas, and then, removing the interlayer insulating film 4 by reactive ion etching using for example a CF₄ gas or an O₂ gas.

After the through hole is fonned, the remaining photoresist is removed by an organic solvent. Thereafter, the second conducting film 10 is deposited as mentioned above.

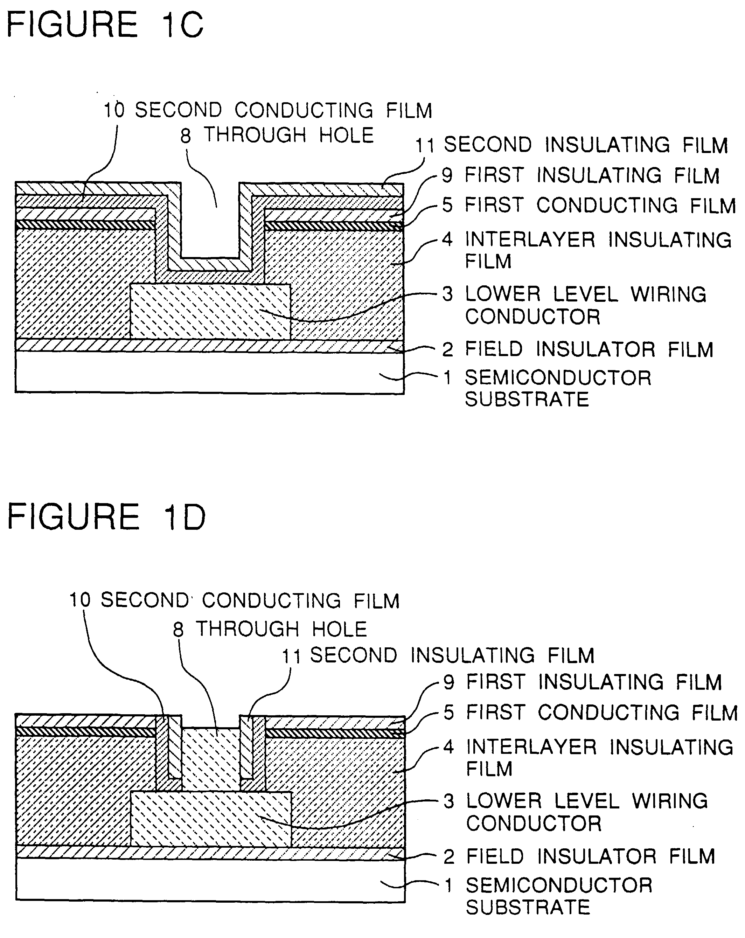

As shown in Figure 1C, on the deposited conducting film 10, a second insulating film 11 is formed by depositing a silicon oxynitride film by a CVD process so as to have a thickness of about 0.1 µm.

As shown in Figure 1D, the reactive ion etching is performed using the CF₄ gas until the first insulating film 9 is exposed, so that the second conducting film 10 and the second insulating film 11 remain only on a side wall surface of the through hole.

With the electroplating process, gold is plating-grown in the through hole 8 until the grown gold reaches the same height as a level of a surface of the first conducting film 5. At this process, an electric current for the electroplating is supplied to the first conducting film 5, the second conducting film and the lower level wiring conductor 3.

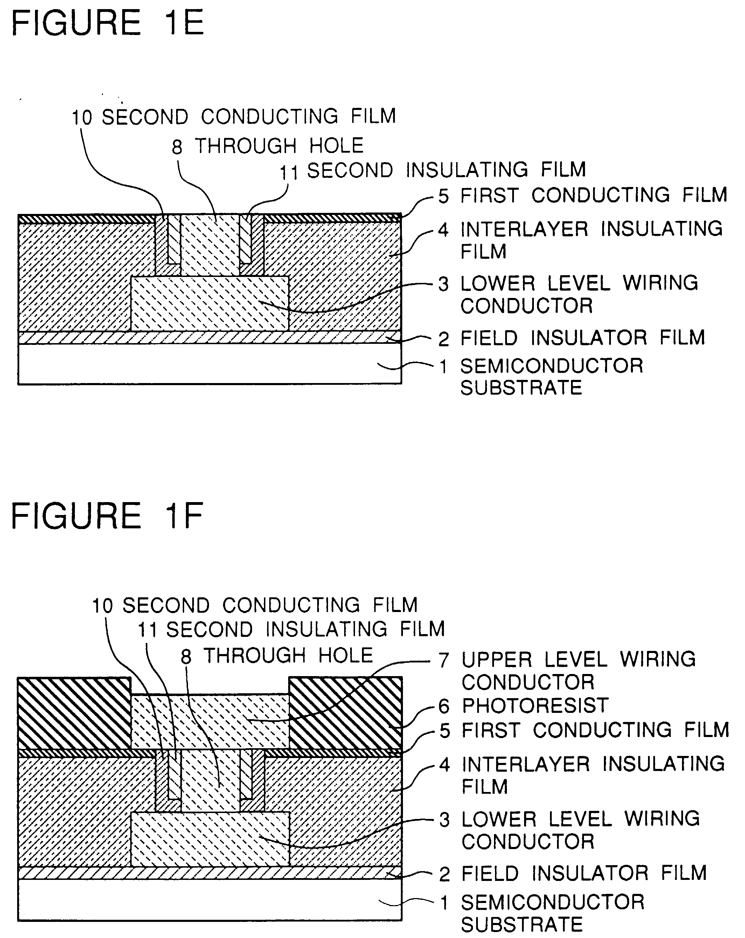

As shown in Figure 1E, after the through hole 8 is filled with the gold plating, a portion of the second insulating film 11, a portion of the second conducting film 10 and the first insulating film 9 are removed by reactive ion etching using the CF₄ gas, so that a planarized surface is obtained.

As shown in Figure 1F, a photoresist 6 is formed on places other than a place where an upper level wiring conductor is to be formed, and an upper level wiring conductor 7 is grown by gold plating, by supplying an electric current for electroplating to the first conducting film 5, the second conducting film 10, the lower level wiring conductor 3, and the gold within the through hole 8.

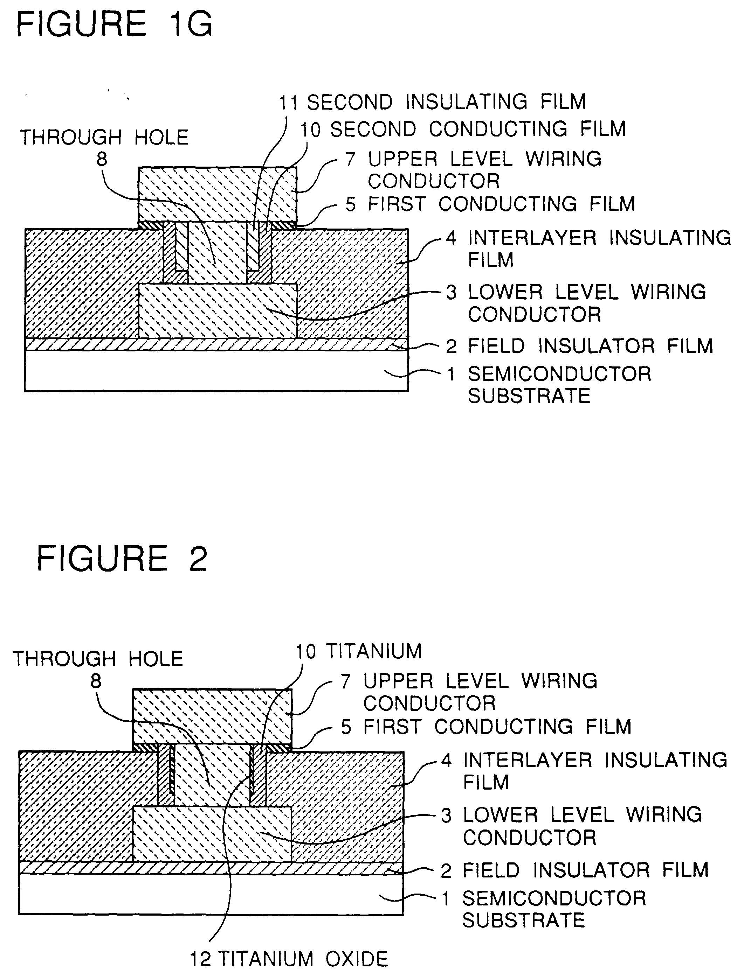

As shown in Figure 1G, after the photoresist is removed, the first conducting film 5 is selectively removed by ion milling using an argon gas. Thus, the present invention is realized.

Thus, the multi-layer wiring structure in the present embodiment has the structure as shown in Figure 1G. Specifically, it comprises the semiconductor substrate 1, the field insulator film 2 formed on the semiconductor substrate 1, the lower level wiring conductor 3 in the desired pattern formed on the field insulator film, and the interlayer insulating film 4 formed on the field insulator film 2 to completely cover the lower level wiring conductor 3. The interlayer insulating film 4 has a thickness sufficiently larger than that of the lower level wiring conductor 3. The interlayer insulating film also has the through hole 8 formed therethrough so as to reach an upper surface of the lower level wiring conductor 3. The conducting film 10 is coated on the side wall surface of the through hole 8, and the insulating film 11 is coated on the conducting film 10. In addition, the conducting film 5 is coated on the interlayer insulating film 4 so as to surround the conducting film 10. The electric conductor material is filled in the through hole 8 in such a manner that one planar surface is constituted of an upper surface of the conducting film 5, an upper end surface of the conducting film 10, an upper end surface of the insulating film 11, and an upper surface of the electric conductor material filled in the through hole 8. The upper level wiring conductor 7 is formed on the planar surface so that the upper level wiring conductor 7 is electrically connected to the lower level wiring conductor 3 through the electric conductor material filled in the through hole 8.

In other words, the through hole 8 in the form of a recessed groove is perforated through the interlayer insulating film 4 for separating the upper level wiring conductor 7 and the lower level wiring conductor 3 from each other, so as to reach a desired position of the lower level wiring conductor 3, and the inside of the through hole 8 in the form of a recessed groove is filled with an electric conductor until the filled conductor reaches a height which is substantially at the same level as the surface of the interlayer insulating film 4, and in addition, the upper level wiring conductor 7 is formed on the interlayer insulating film 4 and on the conductor filled in the inside of the through hole 8.

Figure 2 illustrates at second embodiment of the present invention. In this second embodiment, only the surface of the titanium constituting the second conducting film 10 is oxidized to form an insulating film, by performing a heat-treating at 300°C to 400°C in oxygen atmosphere, in place of depositing the second insulating film 11 in the first embodiment.

In this embodiment, it is possible to omit the step of depositing the insulating film by the CVD process, and also, it is possible to thin the insulating layer. Therefore, it is possible to reduce the through hole 8 in size.

As mentioned above, according to the present invention, the through hole filling and the upper level wiring conductor formation are separately performed by different plating processes, respectively. Therefore, the through hole filling conductor is plating-grown from the surface of the lower level wiring conductor within the through hole, and accordingly, the through hole is compactly filled with the plating metal, with no void at a comer of the through hole.

In addition, since the upper level wiring conductor is plating-grown after the planarization, the shape of the upper level wiring conductor is not limited by the lower level wiring conductor and the shape of the through hole, and therefore, the upper level wiring conductor is relatively planar and may only have a step of the order of a few tens of nanometres high.

The invention has thus been shown and described with reference to the specific embodiments. However, it should be noted that the present invention is in no way limited to the details of the illustrated structures but changes and modifications may be made within the scope of the appended claims.

## Claims

1. A multi-layer wiring structure in a semiconductor device, comprising:
a lower level wiring conductor (3) of a desired pattern formed on a semiconductor substrate (1,2);
an interlayer insulating film (4) formed on said substrate and said lower level wiring conductor, said interlayer insulating film being planarized and having a thickness larger than that of said lower level wiring conductor so as to completely cover said lower level wiring conductor;
a first conducting film (5) coated on an upper surface of said interlayer insulating film, a through hole (8), having a sidewall and a base, being formed through the interlayer insulating film and the first conducting film so as to reach an upper surface of said lower level wiring conductor;
a second conducting film (10) coated on the side wall of said through hole, and contacting said lower level wiring conductor and said first conducting film;
an insulating film (11) coated on said second conducting film;
an electrodeposited electric conductor contacting said lower level wiring conductor at the base of said through hole and filling said through hole such that an upper surface of said first conducting film, an upper end surface of said second conducting film, an upper end surface of said insulating film, and an upper surface of said electric conductor filling said through hole lie in one planar surface; and,
an electrodeposited upper level wiring conductor (7) formed on said planar surface so that said upper level wiring conductor is electrically connected to said lower level wiring conductor through said electric conductor filling said through hole.

2. A multi-layer wiring structure as claimed in Claim 1 wherein said insulating film (11) is formed of a surface oxidized film of said second conducting film.

3. A multi-layer wiring structure As claimed in Claim 2 wherein said second conducting film (10) is formed of titanium, and said insulating film (11) is formed of titanium oxide.

4. A method of manufacturing a multi-layer wiring structure in a semiconductor device comprising the steps of:
depositing an interlayer insulating film (4) to completely cover a lower level wiring conductor (3) of a desired pattern on a semiconductor substrate (1,2), whereby the thickness of the interlayer insulating film is larger than that of the lower level wiring conductor, and planarizing an upper surface of the deposited interlayer insulating film;
forming a first conducting film (5) and a first insulating film (9) on the planarized interlayer insulating film in the named order;
forming a through hole (8) by selectively removing said first insulating film, said first conducting film and said interlayer insulating film at a position where a connection is to be made to said lower level wiring conductor;
forming a second conducting film (10) and a second insulating film (11), in the named order, to cover said first insulating film and an inner surface of said through hole;
etching back said second insulating film and said second conducting film so that only those parts of said second insulating film and said second conducting film covering a side wall of said through hole remain,
performing an electroplating process by supplying an electric current by means of said first conducting film to said second conducting film remaining on said side wall of said through hole and to said lower level wiring conductor, so that an electrically conducting material fills the inside of said through hole to substantially the same height as the level of the upper surface of said first conducting film;
etching back said first insulating film and adjacent uppermost end portions of the parts of said second conducting film and said second insulating film remaining on said side wall of said through hole until the upper surface of said first conducting film is exposed, so that the upper surface of said first conducting film, upper end portions of said second conducting film and said second insulating film remaining on said side wall of said through hole, and an upper surface of said electrically conducting material filling said through hole form a planar surface;
forming a photoresist (6) on said planar surface except at a place where an upper level wiring conductor (7) is to be formed;
performing an electroplating process by supplying an electric current via said first conducting film to said second conducting film remaining on said side wall of said through hole, said lower level wiring conductor and said electrically conducting material filling said through hole, to form an upper level wiring conductor (7) on at least the upper surface of said electrically conducting material filling said through hole and a portion of said first conducting film not covered by said photoresist; and,
removing said photoresist and said first conducting film except any portion thereof over which said upper level wiring conductor was formed.

5. A method as claimed in Claim 4 wherein said formation of said second conducting film and said second insulating film is performed by sequentially depositing said second conducting film and said second insulating film.

6. A method as claimed in Claim 4 wherein said formation of said second conducting film and said second insulating film is performed by depositing a metal layer as said second conducting film and then oxidizing a surface of said metal layer so as to form a surface oxidized film as said second insulating film.

7. A method as claimed in Claim 4, 5 or 6 wherein said first conducting film and said second conducting film are formed of titanium.

8. A method as claimed in any of Claims 4 to 7 wherein said formation of said interlayer insulating film is performed by growing a silicon oxide film by a CVD process, and then by spin-coating a polyimide layer, and by heating the coated polyimide layer.

9. A method as claimed in Claim 4, 5, 7 or 8 wherein said first insulating film and said second insulating film are formed by depositing silicon oxynitride films by a CVD process.

## Patentansprüche

1. Mehrlagige Verbindungsstruktur in einer Halbleitervorrichtung, die aufweist:
einen Verbindungsleiter der unteren Ebene(3) mit einem auf einem Halbleitersubstrat (1,2) ausgebildeten gewünschten Muster ;
eine auf dem Substrat und dem Verbindungsleiter der unteren Ebene ausgebildete Zwischenlagenisolierschicht (4), wobei diese Zwischenlagenisolierschicht geebnet ist und eine größere Dicke aufweist, als die des Verbindungsleiters der unteren Ebene, um den Verbindungsleiter der unteren Ebene vollständig zu bedecken;
eine erste auf eine obere Oberfläche der Zwischenlagenisolierschicht aufgebrachte leitende Schicht (5), ein Durchgangsloch (8), das eine Seitenwand und eine Grundfläche aufweist, das durch die Zwischenlagenisolierschicht und die erste leitende Schicht gebildet wird, um eine obere Oberfläche des Verbindungsleiters der unteren Ebene zu erreichen;
eine zweite auf die Seitenwand des Durchgangslochs aufgebrachte und den Verbindungsleiter der unteren Ebene und die erste leitende Schicht berührende leitende Schicht (10);
eine auf die zweite leitende Schicht aufgebrachte Isolierschicht (11);
einen galvanisch niedergeschlagenen elektrischen Leiter, der den Verbindungsleiter der unteren Ebene an der Grundfläche des Durchgangslochs berührt und das Durchgangsloch ausfüllt, so daß eine obere Oberfläche der ersten leitenden Schicht, eine obere Endoberfläche der zweiten leitenden Schicht, eine obere Endoberfläche der Isolierschicht, und eine obere Oberfläche des elektrischen Leiters, der das Durchgangsloch ausfüllt, in einer ebenen Oberfläche liegen; und,
einen galvanisch niedergeschlagenen Verbindungsleiter der oberen Ebene (7), der so auf der ebenen Oberfläche ausgebildet ist, daß der Verbindungsleiter der oberen Ebene elektrisch mit dem Verbindungsleiter der unteren Ebene durch den elektrischen Leiter, der das Durchgangsloch ausfüllt, verbunden ist.

2. Mehrlagige Verbindungsstruktur nach Anspruch 1, in dem die Isolierschicht (11) aus einer oberflächenoxydierten Schicht der zweiten leitenden Schicht gebildet ist.

3. Mehrlagige Verbindungsstruktur nach Anspruch 2, in dem die zweite leitende Schicht (10) aus Titan gebildet wird, und die Isolierschicht (11) aus Titanoxyd gebildet wird.

4. verfahren zur Herstellung einer mehrlagigen Verbindungsstruktur in einer Halbleitervorrichtung, das die Schritte aufweist:
Niederschlagen einer Zwischenlagenisolierschicht (4), um einen Verbindungsleiter der unteren Ebene (3) mit einem gewünschten Muster auf einem Halbleitersubstrat (1,2) vollständig zu bedecken, wobei die Dicke der Zwischenlagenisolierschicht größer als die des Verbindungsleiters der unteren Ebene ist, und ebnen einer oberen Oberfläche der niedergeschlagenen Zwischenlagenisolierschicht;
Bilden einer ersten leitenden Schicht (5) und einer ersten Isolierschicht (9) auf der geebneten Zwischenlagenisolierschicht in der genannten Reihenfolge;
Bilden eines Durchgangsloch (8) durch selektives Entfernen der ersten Isolierschicht, der ersten leitenden Schicht und der Zwischenlagenisolierschicht an einer Stelle, wo eine Verbindung zu dem Verbindungsleiter der unteren Ebene hergestellt werden soll;
Bilden einer zweiten leitenden Schicht (10) und einer zweiten Isolierschicht (11) in der genannten Reihenfolge, um die erste Isolierschicht und eine innere Oberfläche des Durchgangslochs zu bedecken;
Rückätzen der zweiten Isolierschicht und der zweiten leitenden Schicht, so daß nur die Teile der zweiten Isolierschicht und der zweiten leitenden Schicht übrigbleiben, die eine Seitenwand des Durchgangslochs bedecken,
Durchführen eines Elektroplattierungsprozesses durch Liefern eines elektrischen Stroms mittels der ersten leitenden Schicht an die an der Seitenwand des Durchgangslochs übrigbleibende zweite leitende Schicht und an den Verbindungsleiter der unteren Ebene, so daß ein elektrisch leitendes Material das Innere des Durchgangslochs bis zur im wesentlichen gleichen Höhe wie das Niveau der oberen Oberfläche der ersten leitenden Schicht auffüllt;
Rückätzen der ersten Isolierschicht und benachbarter oberster Endabschnitte der Teile der zweiten leitenden Schicht und der zweiten Isolierschicht, die an der Seitenwand des Durchgangslochs übrigbleiben, bis die obere Oberfläche der ersten leitenden Schicht freigelegt wird, so daß die obere Oberfläche der ersten leitenden Schicht, obere Endabschnitte der zweiten leitenden Schicht und die an der Seitenwand des Durchgangslochs übrigbleibende zweite Isolierschicht, und eine obere Oberfläche des elektrisch leitenden Materials, das das Durchgangsloch ausfüllt, eine ebene Oberfläche bilden;
Bilden eines Photoresists (6) auf der ebenen Oberfläche außer an einer Stelle, wo ein Verbindungsleiter der oberen Ebene (7) gebildet werden soll;
Durchführen eines Elektroplattierungsprozesses durch Zuführung eines elektrischen Stroms über die erste leitende Schicht an die an der Seitenwand des Durchgangslochs übrigbleibende zweite leitende Schicht, den Verbindungsleiter der unteren Ebene und das elektrisch leitende Material, das das Durchgangsloch ausfüllt, um einen Verbindungsleiter der oberen Ebene (7) an mindestens der oberen Oberfläche des elektrisch leitenden Materials, das das Durchgangsloch ausfüllt, und einem nicht durch das Photoresist bedeckten Abschnitt der ersten leitenden Schicht zu bilden; und,
Entfernen des Photoresists und der ersten leitenden Schicht außer irgendeines Abschnitts derselben, über den der Verbindungsleiter der oberen Ebene gebildet wurde.

5. Verfahren nach Anspruch 4, in dem der Aufbau der zweiten leitenden Schicht und der zweiten Isolierschicht durch aufeinanderfolgendes Niederschlagen der zweiten leitenden Schicht und der zweiten Isolierschicht durchgeführt wird.

6. Verfahren nach Anspruch 4, in dem der Aufbau der zweiten leitenden Schicht und der zweiten Isolierschicht durch Niederschlagen einer Metallage als die zweite leitende Schicht und folgendes Oxydieren einer Oberfläche der Metallage durchgeführt wird, um eine oberflächenoxydierte Schicht als die zweite Isolierschicht zu bilden.

7. Verfahren nach Anspruch 4, 5 oder 6, in dem die erste leitende Schicht und die zweite leitende Schicht aus Titan gebildet werden.

8. Verfahren nach einem der Ansprüche 4 bis 7, in dem der Aufbau der Zwischenlagenisolierschicht durch Züchten einer Siliziumoxydschicht durch einen CVD-Prozeß durchgeführt wird, und dann durch Schleuderbeschichten einer Polyimidlage, und durch Erwärmen der beschichteten Polyimidlage durchgeführt wird.

9. Verfahren nach Anspruch 4, 5, 7 oder 8, in dem die erste Isolierschicht und die zweite Isolierschicht durch Niederschlagen einer Siliziumoxynitridschicht durch einen CVD-Prozeß gebildet wird.

## Revendications

1. Structure d'interconnexions multicouches pour un dispositif semiconducteur, comprenant :
un conducteur d'interconnexion de niveau inférieur (3) d'une configuration désirée formé sur un substrat semiconducteur (1, 2) ;
une couche isolante intermédiaire (4) formée sur ledit substrat et sur ledit conducteur d'interconnexion de niveau inférieur, ladite couche isolante intermédiaire étant rendue plane et ayant une épaisseur supérieure à celle dudit conducteur d'interconnexion de niveau inférieur de manière à recouvrir complètement ledit conducteur d'interconnexion de niveau inférieur;
une première couche conductrice (5) appliquée sur une surface supérieure de ladite couche isolante intermédiaire, un trou traversant (8), ayant une paroi latérale et une base, étant formé à travers la couche isolante intermédiaire et la première couche conductrice de manière à atteindre une surface supérieure dudit conducteur d'interconnexion de niveau inférieur;
une seconde couche conductrice (10) appliquée sur la paroi latérale dudit trou traversant, et contactant ledit conducteur d'interconnexion de niveau inférieur et ladite première couche conductrice ;
une couche isolante (11) appliquée sur ladite seconde couche conductrice ;
un conducteur électrique, déposé par électrolyse, contactant ledit conducteur d'interconnexion de niveau inférieur à la base dudit trou traversant et remplissant ledit trou traversant de sorte qu'une surface supérieure de ladite première couche conductrice, une surface terminale supérieure de ladite seconde couche conductrice, une surface terminale supérieure de ladite couche isolante, et une surface supérieure dudit conducteur électrique remplissant ledit trou traversant se trouvent dans une surface plane ; et,
un conducteur d'interconnexion de niveau supérieur (7), déposé par électrolyse, formé sur ladite surface plane de telle sorte que ledit conducteur d'interconnexion de niveau supérieur soit relié électriquement audit conducteur d'interconnexion de niveau inférieur par l'intermédiaire dudit conducteur électrique remplissant ledit trou traversant.

2. Structure d'interconnexions multicouches selon la revendication 1, dans laquelle ladite couche isolante (11) est formée d'une couche oxydée en surface de ladite seconde couche conductrice.

3. Structure d'interconnexions multicouches selon la revendication 2, dans laquelle ladite seconde couche conductrice (10) est formée de titane, et ladite couche isolante (11) est formée d'oxyde de titane.

4. Procédé de fabrication d'une structure d'interconnexions multicouches pour un dispositif semiconducteur, comprenant les étapes consistant à :
déposer une couche isolante intermédiaire (4) de manière à recouvrir complètement un conducteur d'interconnexion de niveau inférieur (3) d'une configuration désirée sur un substrat semiconducteur (1, 2), de sorte que l'épaisseur de la couche isolante intermédiaire soit supérieure à celle du conducteur d'interconnexion de niveau inférieur, et à rendre plane une surface supérieure de la couche isolante intermédiaire déposée ;
former une première couche conductrice (5) et une première couche isolante (9) sur la couche isolante intermédiaire rendue plane, dans l'ordre désigné ;
former un trou traversant (8) en retirant sélectivement ladite première couche isolante, ladite première couche conductrice et ladite couche isolante intermédiaire en un endroit où une connexion doit être faite avec ledit conducteur d'interconnexion de niveau inférieur;
former une seconde couche conductrice (10) et une seconde couche isolante (11), dans l'ordre désigné, pour recouvrir ladite première couche isolante et une surface intérieure dudit trou traversant ;
attaquer chimiquement ladite seconde couche isolante et ladite seconde couche conductrice de sorte que seules restent les parties de ladite seconde couche isolante et de ladite seconde couche conductrice recouvrant une paroi latérale dudit trou traversant ;
effectuer une opération d'électrodéposition en appliquant un courant électrique au moyen de ladite première couche conductrice à ladite seconde couche conductrice restant sur ladite paroi latérale dudit trou traversant et audit conducteur d'interconnexion de niveau inférieur, de sorte qu'une matière électriquement conductrice remplisse l'intérieur dudit trou traversant sensiblement jusqu'à la même hauteur que le niveau de la surface supérieure de ladite première couche conductrice ;
attaquer chimiquement ladite première couche isolante et les parties terminales supérieures adjacentes des parties de ladite seconde couche conductrice et de ladite seconde couche isolante restant sur ladite paroi latérale dudit trou traversant jusqu'à ce que la surface supérieure de ladite première couche conductrice soit découverte, de sorte que la surface supérieure de ladite première couche conductrice, les parties terminales supérieures de ladite seconde couche conductrice et de ladite seconde couche isolante restant sur ladite paroi latérale dudit trou traversant, et une surface supérieure de ladite matière électriquement conductrice remplissant ledit trou traversant forment une surface plane;
former un photorésist (6) sur la dite surface plane excepté à un endroit où un conducteur d'interconnexion de niveau supérieur (7) doit être formé ;
effectuer une opération d'électrodéposition en appliquant un courant électrique par l'intermédiaire de ladite première couche conductrice à ladite seconde couche conductrice restant sur ladite paroi latérale dudit trou traversant, audit conducteur d'interconnexion de niveau inférieur et à ladite matière électriquement conductrice remplissant ledit trou traversant, pour former un conducteur d'interconnexion de niveau supérieur (7) sur au moins la surface supérieure de ladite matière électriquement conductrice remplissant ledit trou traversant et une partie de ladite première couche conductrice non recouverte par ledit photorésist ; et,
retirer ledit photorésist et ladite première couche conductrice excepté toute partie de celle-ci sur laquelle ledit conducteur d'interconnexion de niveau supérieur a été formé.

5. Procédé selon la revendication 4, dans lequel ladite formation de ladite seconde couche conductrice et de ladite seconde couche isolante est effectuée en déposant successivement ladite seconde couche conductrice et de ladite seconde couche isolante.

6. Procédé selon la revendication 4, dans lequel ladite formation de ladite seconde couche conductrice et de ladite seconde couche isolante est effectuée en déposant une couche métallique à titre de ladite seconde couche conductrice et en oxydant ensuite une surface de ladite couche métallique de manière à former une couche oxydée en surface à titre de ladite seconde couche isolante.

7. Procédé selon la revendication 4, 5 ou 6, dans lequel ladite première couche conductrice et ladite seconde couche conductrice sont formées de titane.

8. Procédé selon l'une quelconque des revendications 4 à 7, dans lequel ladite formation de ladite couche isolante intermédiaire est effectuée en formant une couche d'oxyde de silicium par un procédé de dépôt par voie chimique en phase vapeur, et en appliquant ensuite par centrifugation une couche de polyimide, et en chauffant la couche de polyimide appliquée.

9. Procédé selon la revendication 4, 5, 7 ou 8, dans lequel ladite première couche isolante et ladite seconde couche isolante sont formées en déposant des couches d'oxynitrure de silicium par un procédé de dépôt par voie chimique en phase vapeur.
